# EUROPEAN PATENT APPLICATION

(11) **EP 2 469 550 A2**
(43) Date of publication of application: **27.06.2012**
(21) Application number: 11185560.7
(22) Date of filing: 18.10.2011
(51) Int. Cl.: H01G 9/20, H01L 51/00

(54) **Photoelectrode for dye sensitized solar cell, solar cell including photoelectrode, and method of manufacturing the photoelectrode**

(30) Priority: 24.12.2010 KR 20100134885
(71) Applicant: Samsung SDI Co., Ltd., Gyeonggi-do 449-577 (KR)
(72) Inventor: Park, Do-Young, Gyeonggi-do (KR); Lee, Ji-Won, Gyeonggi-do (KR); Shin, Byong-Cheol, Gyeonggi-do (KR); Kang, Moon-Sung, Gyeonggi-do (KR); Cha, Si-Young, Gyeonggi-do (KR)
(74) Representative: Gulde Hengelhaupt Ziebig & Schneider

(57) **Abstract**

The present invention relates to a photoelectrode for a dye-sensitized solar cell. The photoelectrode includes a coating product of a composition including a metal oxide, an acid, a first additive comprising one or more compounds represented by Formula 1 below, and a second additive comprising one or more compounds represented by Formula 2 below: 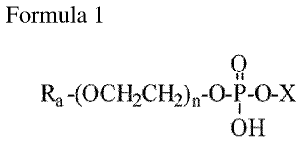 wherein in Formula 1, Rₐ is a C10 to C30 alkyl group, X is a hydrogen atom or - (CH₂CH₂O)ₙ-R_{b}, n is an integer of 1 to 20, and R_{b} is a C10 to C30 alkyl group, and 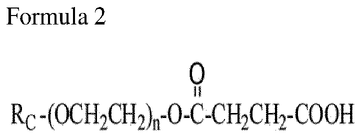 wherein in Formula 2, R_{c} is a C10 to C30 alkyl group, and n is an integer of 1 to 20.

## Description

The present invention relates to a photoelectrode for a dye-sensitized solar cell, a solar cell including the photoelectrode, and a method of manufacturing the photoelectrode.

### Description of the Related Technology

Dye-sensitized solar cells are photoelectrochemical solar cells including photosensitive dye molecules that absorb visible light, unlike a silicon solar cell, to generate an electron-hole pair, and a transition metal oxide for transferring generated electrons.

Dye-sensitized solar cells are transparent and have relatively low manufacturing costs compared to a conventional silicon solar cell, and thus, they can be used in glass windows in an outer wall of a building or in a glass greenhouse. However, dye-sensitized solar cells still need to be improved to achieve low haze and high transmittance, which is required in a building-integrated photovoltaic (BIPV) system.

### SUMMARY

The present invention provides a method of manufacturing a photoelectrode for a dye-sensitized solar cell having low haze and high transmittance, which is required in a building-integrated photovoltaic (BIPV) system, the photoelectrode achieved by the manufacturing method, and a dye-sensitized solar cell including the photoelectrode.

Additional aspects will be set forth in part in the description which follows and, in part, will be apparent from the description, or may be learned by practice of the presented embodiments.

According to one aspect of the present invention, there is provided a photoelectrode for a dye-sensitized solar cell as claimed in claim 1.

According to another aspect of the present invention, there is provided the method of preparing a photoelectrode for a dye-sensitized solar cell of claim 11.

Another aspect of the present invention refers to a dye-sensitized solar cell including: a first electrode; the photoelectrode described above formed on a surface of the first electrode; a second electrode disposed facing the first electrode on which the photoelectrode is disposed; and an electrolyte disposed between the first electrode and the second electrode.

### BRIEF DESCRIPTION OF THE DRAWINGS

These and/or other aspects will become apparent and more readily appreciated from the following description of the embodiments, taken in conjunction with the accompanying drawings of which:
FIG. 1 is a graph of viscosity of TiO₂ compositions prepared according to Example 1, Comparative Example 1 and Comparative Example 2; and
FIG. 2 is a schematic sectional view of a dye-sensitized solar cell according to an embodiment.

### DETAILED DESCRIPTION

Reference will now be made in detail to embodiments, examples of which are illustrated in the accompanying drawings, wherein like reference numerals refer to like elements throughout

A photoelectrode for a dye-sensitized solar cell according to the present invention includes a coating product of a composition including a metal oxide, an acid, a first additive including one or more compounds represented by Formula 1 below, and a second additive including one or more compounds represented by Formula 2 below: 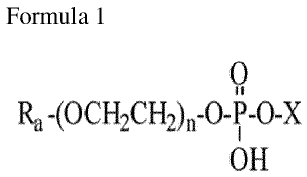 wherein in Formula 1, Rₐ is a C₁₀ to C₃₀ alkyl group, X is a hydrogen atom or - (CH₂CH₂O)ₙ-R_{b}, n is an integer of 1 to 20, R_{b} is a C₁₀ to C₃₀ alkyl group, and 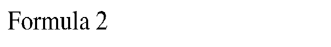 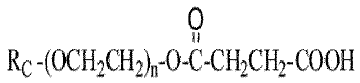 wherein in Formula 2, R_{c} is a C₁₀ to C₃₀ alkyl group, and n is an integer of 1 to 20.

A mole ratio of the first additive to the second additive may be 1:4 to 4:1.

The first additive may be used as a dispersing agent, and an amount of the first additive may be 1 to 15 parts by weight based on 100 parts by weight of the metal oxide. If the amount of the first additive is within the range described above, the composition may have good dispersing characteristics and a relatively small particle size.

The first additive may be a mixture including a compound represented by Formula 3 below and a compound represented by Formula 4 below. An amount of the mixture may be 1 to 15 parts by weight based on 100 parts by weight of the metal oxide. If the amount of the mixture is within the range described above, the composition may have good dispersing characteristics and a relatively small particle size.

A mole ratio of the compound of Formula 3 to the compound of Formula 4 may be 1:4 to 4: 1, for example, 1:2 to 2: 1. If the mole ratio of the compound of Formula 3 to the compound of Formula 4 is within this mole ratio range, the composition may have good dispersing characteristics, and a relatively small particle size. 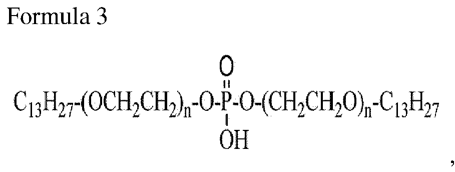 and 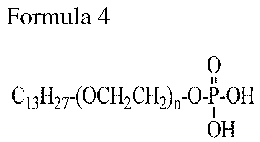 wherein in Formulae 3 and 4, n is an integer of 1 to 14.

The second additive including one or more compounds represented by Formula 2 may be used as a dispersing agent, and an amount of the second additive may be 1 to 15 parts by weight based on 100 parts by weight of the metal oxide. If the amount of the second additive is within the range described above, the composition may have good dispersing characteristics. Also, the composition may have good viscosity characteristics at a low shear rate and thus good printing characteristics.

The second additive may be a mixture comprising a compound represented by Formula 5 below and a compound represented by Formula 6. An amount of the mixture may be 1 to 15 parts by weight based on 100 parts by weight of the metal oxide. If the amount of the mixture is within the range described above, the composition may have good dispersing characteristics. Also, the composition may have good viscosity characteristics at a low shear rate and thus good printing characteristics.

A mole ratio of the compound of Formula 5 to the compound of Formula 6 may be from 1:4 to 4:1, for example from 1:2 to 2:1. If the mole ratio of the compound of Formula 5 to the compound of Formula 6 is within the mole ratio range, the composition may have good dispersing characteristics. Also, the composition may have good viscosity characteristics at a low shear rate and thus good printing characteristics. 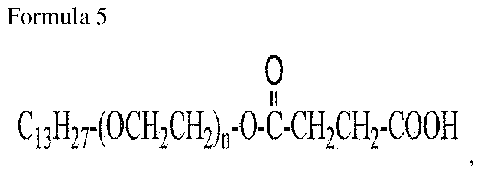 and 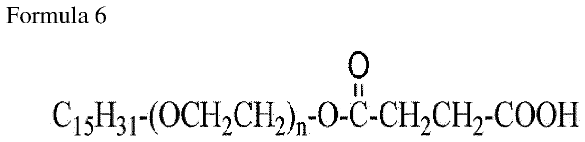 Wherein in Formulae 5 and 6, n is an integer of 1 to 14.

In order to manufacture the photoelectrode, the composition may be coated on a transparent substrate to form a metal oxide layer. In this regard, the coating method is not limited, and may be spraying, spin coating, dipping, printing, doctor blading, sputtering, etc.

After the coating, drying and calcinating may be performed. The drying may be performed at a temperature of 50 to 180°C, and the calcinating may be performed at a temperature of 400 to 600°C

The photoelectrode may further include a dye on the metal oxide layer. Dye particles are adsorbed to a surface of metal oxide of the metal oxide layer, and absorb light so that electrons transition from a ground state to an excited state to form an electron-hole pair and the excited electrons are injected to a conduction band of the metal oxide and move toward the photoelectrode, thereby generating an electromotive force.

A dye for use in the photoelectrode may be any one of various dyes that have charge separation characteristics, are dye-sensitized, and used in a conventional solar cell. For example, the dye may be a ruthenium complex. The dye may also be, in addition to a ruthenium complex, an xanthine pigment, such as rhodamine B, rose bengal, eosine, or erythrocin; a cyanine-based pigment, such as quinocyanine or cryptocyanine; a basic dye, such as phenosafranine, capriblue, tyocyn, or methylenblue; a porphyrin-based compound, such as chlorophyll, zinc porphyrin, or magnesium prophyrin; an azo pigment; a complex, such as a phthalocyanin compound, or a Ru trisbipyridyl; an anthraquinone-based pigment; a multi-cyclic quinine-based pigment; or a combination thereof. The ruthenium complex may be RuL₂(SCN)₂, RuL₂(H₂O)₂, RuL₃, or RuL₂ where L is 2,2'-bipyridyl-4,4'-dicarboxylate.

A method of manufacturing a photoelectrode for a dye-sensitized solar cell, according to an embodiment, includes preparing a metal oxide composition for forming a photoelectrode for a dye-sensitized solar cell.

The method of manufacturing a photoelectrode for a dye-sensitized solar cell includes: preparing a first composition by mixing a metal oxide, a first solvent, and an acid; preparing a second composition by adding a first additive including one or more compounds represented by Formula 1 to the first composition; preparing a third composition by adding a binder and a second solvent to the second composition; preparing a metal oxide composition by adding a second additive comprising one or more compounds represented by Formula 2 to the third composition; and coating and heat treating the metal oxide composition on a substrate.

The preparing of the first composition may further include sonicating the first composition prepared by mixing the metal oxide, the first solvent, and the acid.

The method may further include milling of the second composition prepared by adding the first additive including one or more compounds represented by Formula 1 to the first composition. The milling may not be limited and may be, for example, Apex milling.

The first solvent may be any one of various solvents that uniformly disperse the metal oxide, and examples of the first solvent are water, acetone, methanol, ethanol, isopropylalcohol, n-propylalcohol, butanol, α-α-terpineol, dimethylacetamide, dimethylformamide, dimethylsulfoxide, N-methyl-2-pyrrolidone, tetrahydrofurane, tetrabutylacetate, n-butylacetate, 2-(2-butoxyethoxy)ethyl acetate), m-cresol, toluene, ethylgylcol, gamma-butyrolactone, hexafluoroisopropanol (HFIP), N,N-dimethylforamide (DMF), hexane, and a combination thereof.

The first additive may be used as a dispersing agent, and the first additive may include one or more compounds represented by Formula 1.

Also, an amount of the first additive may be 1 to 15 parts by weight based on 100 parts by weight of the metal oxide. If the amount of the first additive is within the range described above, the second composition may have good dispersing characteristics. Also, the addition of the first additive may lead to a smaller particle size of the second composition.

The first additive may be a mixture of a compound represented by Formula 3 and a compound represented by Formula 4. A mole ratio of the compound of Formula 3 to the compound of Formula 4 may be from 1:4 to 4: 1. If the mole ratio of the compound of Formula 3 to the compound of Formula 4 is within the mole ratio range, the second composition may have good dispersing characteristics. Also, due to the addition of the first additive, the second composition has a relatively smaller particle size.

The second additive may be used as a dispersing agent, and the second additive may include one or more compounds represented by Formula 2.

An amount of the second additive May be from 1 to 15 parts by weight based on 100 parts by weight of the metal oxide. If the amount of the second additive is within the range described above, the metal oxide composition may have good dispersing characteristics. Also, the metal oxide composition may have good viscosity characteristics at a low shear rate and thus good printing characteristics.

The second additive may be a mixture including a compound represented by Formula 5 and a compound represented by Formula 6.

A mole ratio of the compound of Formula 5 to the compound of Formula 6 may be from 1:4 to 4:1. If the mole ratio of the compound of Formula 5 to the compound of Formula 6 is within the mole ratio range, the metal oxide composition may have good dispersing characteristics. Also, the metal oxide composition may have good viscosity characteristics at a low shear rate and thus good printing characteristics.

In the preparing of the third composition, the binder is dissolved in the second solvent and the second solvent is additionally added to the resultant mixture.

The second solvent may be any one of the examples of the first solvent as presented above.

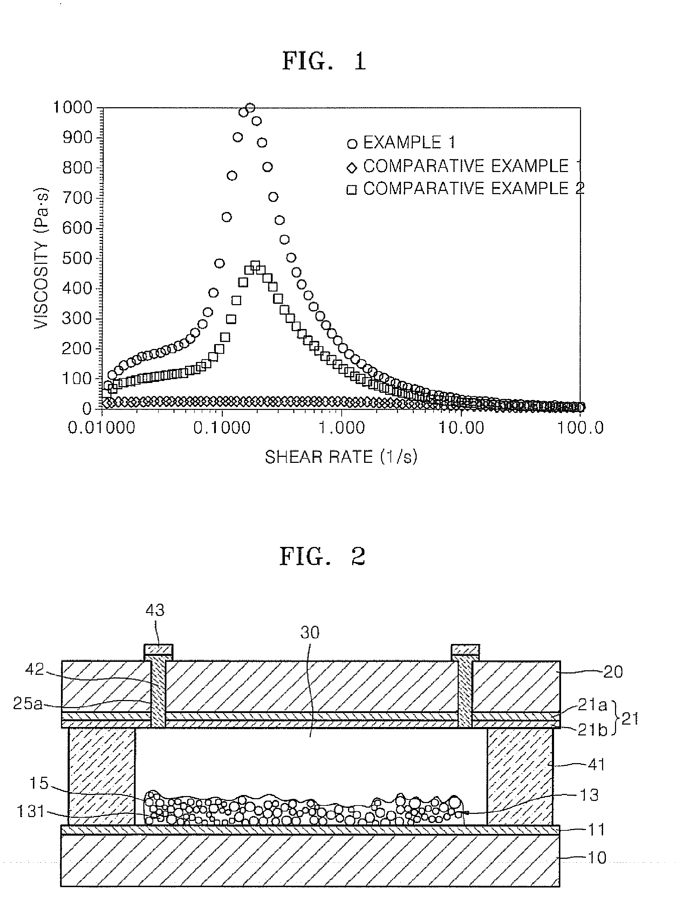

In the preparing of the metal oxide composition, the second additive is added to the third composition to allow the third composition to be easily dispersed so as to adjust a viscosity of the metal oxide composition to be such a level that the metal oxide composition is easily coated on the substrate. The metal oxide composition is coated on the substrate and heat treated to complete manufacturing of the photoelectrode. When the second additive is added to the third composition, a viscosity of the metal oxide composition at a low shear rate is low. The decrease in viscosity at a low shear rate is confirmed with reference to FIG. 1. Thus, the metal oxide composition has good rheological characteristics and good printing characteristics.

The metal oxide may include TiO₂, SnO₂, WO₃, ZnO, SiO₂, ZrO₂, MgO, SrTiO₃, Al₂O₃, or a combination thereof.

The acid may be, for example, a nitric acid, a hydrochloric acid, or an acetic acid.

The binder may be one selected from the group consisting of methylcellulose, ethylcellulose, propylcellulose, nitrocellulose, acetacidcellulose, propionacidcellulose, hydroxyethyl cellulose, hydroxypropyl cellulose, hydroxyethylhydroxypropyl cellulose, and a combination thereof.

A dye-sensitized solar cell according to an embodiment includes a first electrode; a photoelectrode formed on a surface of the first electrode; a second electrode disposed facing the first electrode on which the photoelectrode is disposed; and an electrolyte disposed between the first electrode and the second electrode.

FIG. 2 is a schematic sectional view of a dye-sensitized solar cell according to an embodiment.

Referring to FIG. 2, the dye-sensitized solar cell according to the present embodiment includes a first substrate 10, a first electrode 11, a photoelectrode 13, a dye 15, a second substrate 20, a second electrode 21 disposed on the second substrate 20, and an electrolyte 30 disposed between the first electrode 11 and the second electrode 21, in which the first electrode 11, the photoelectrode 13, and the dye 15 are disposed on the first substrate 10, and the first substrate 10 faces the second substrate 20. A separate case (not shown) may be disposed outside the first substrate 10 and the second substrate 20. The structure of the dye-sensitized solar cell will now be described in detail.

In the present embodiment, the first substrate 10 functions as a support for the first electrode 11 and is transparent to allow external light to enter inside the dye-sensitized solar cell. The first substrate 10 may include glass or a plastic material. Examples of a plastic material are poly ethylene terephthalate (PET), poly ethylene naphthalate (PEN), poly carbonate (PC), poly propylene (PP), poly imide (PI), and tri acetyl cellulose (TAC).

The first electrode 11 formed on the first substrate 10 may include one selected from the group consisting of indium tin oxide, indium oxide, tin oxide, zinc oxide, sulfur oxide, fluorine oxide, ZnO-Ga₂O₃ or ZnO-Al₂O₃, and a combination thereof. The first electrode 11 may be a single or stacked layer comprising the transparent materials.

The photoelectrode 13 is formed on the first electrode 11. The photoelectrode 13 may have a thickness of about 10 nm to about 3000 nm, for example, about 10 nm to about 1000 nm. However, the thickness of the photoelectrode 13 may not be limited thereto and may vary according to a degree of technology development.

The dye 15 that absorbs external light to generate excited electrons is adsorbed to a surface of the photoelectrode 13.

The dye 15 may be an organic dye that has a high mole absorption coefficient, high photoelectric efficiency, and low manufacturing costs, as an alternative to an inorganic dye that is used in conventional cases and is expensive.

The second substrate 20 facing the first substrate 10 functions as a support for the second electrode 21, and may be transparent. Like the first substrate 10, the second substrate 20 may include glass or a plastic material.

The second electrode 21 formed on the second substrate 20 may be disposed facing the first electrode 11, and may include a transparent electrode 21a and a catalyst electrode 21b.

The transparent electrode 21a may include a transparent material, such as an indium tin oxide, a fluoro tin oxide, an antimony tin oxide, a zinc oxide, a tin oxide, ZnO-Ga₂O₃, or ZnO-Al₂O₃. The transparent electrode 21a may be a single or stacked layer of the transparent materials. The catalyst electrode 21b may activate a redox couple, and examples thereof are platinum, ruthenium, palladium, iridium, rhodium (Rh), osmium (Os), carbon (C), WO₃, TiO₂, etc.

The first substrate 10 is bonded to the second substrate 20 by an adhesive 41, and the electrolyte 30 is injected via a hole 25a that passes through the second substrate 20 and the second electrode 21 so that the first electrode 11 and the second electrode 21 are impregnated with the electrolyte 30. The electrolyte 30 uniformly disperses into the photoelectrode 13. The electrolyte 30 receives electrons from the second electrode 21 by oxidation and reduction and transfers the electrons to the dye 15. The hole 25a that passes through the second substrate 20 and the second electrode 21 is sealed by the adhesive 42 and a cover glass 43.

Although not illustrated in FIG. 2, a metal oxide film, which is a conventional porous film, may be further formed between an upper surface of the first electrode 11 and a lower surface of the photoelectrode 13. In this case, the photoelectrode 13 functions as a light scattering electrode and adsorbs a great amount of dye. Thus, use of the photoelectrode 13 overcomes disadvantages of a conventional light scattering electrode, thereby increasing efficiency of a dye-sensitized solar cell.

The porous film may include metal oxide particles, such as titanium dioxide, zinc oxide, tin oxide, strontium oxide, indium oxide, iridium oxide, lanthan oxide, vanadium oxide, molybdenum oxide, tungsten oxide, niobium oxide, magnesium oxide, aluminium oxide, yttrium oxide, scandium oxide, samarium oxide, galluim oxide, or strontium titanium oxide. For example, the metal oxide particles may include titanium dioxide (TiO₂), tin oxide (SnO₂), tungsten oxide (WO₃), zinc oxide (ZnO), or a combination thereof.

The present embodiments will be described in further detail with reference to the following examples.

### Example 1

### Preparation of TiO₂ composition for forming photoelectrode

In order to disperse TiO₂ powder having an average particle diameter of 20 nm, a first composition including 170 g of TiO₂ powder, 830 g of ethanol, and 10 ml of nitric acid were sonificated for 1 hour. Then, 8.5 g of a mixture including a compound represented by Formula 3 and a compound represented by Formula 4 at a mole ratio of 2:1 was added to the first composition to prepare a second composition. The second composition was dispersed by using an Apex mill for 4 hours.

510 g of a vehicle prepared by adding 51 g of ethyl cellulose to 137.7 g of 2-(2-butoxyethoxy) ethyl acetate and 321.3 g of α-terpineol to liquidize, and 320 g of a solvent including 2-(2-butoxyethoxy)ethyl acetate and α-terpineol at a weight ratio of 3:7 were added to the dispersed second composition to prepare a third composition. 5.1 g of a mixture including a compound represented by Formula 5 and a compound represented by Formula 6 at a mole ratio of 1:2 was added to the third composition, thereby completing preparation of a TiO₂ composition.

### Comparative Example 1

### Preparation of TiO₂ composition for forming amine-based photoelectrode

A TiO₂ composition for forming an amine-based photoelectrode was prepared in the same manner as in Example 1, except that an amine-based compound was used instead of the mixture including the compound represented by Formula 3 and the compound represented by Formula 4 at a mole ratio of 2: 1, and the mixture including the compound represented by Formula 5 and the compound represented by Formula 6 at a mole ratio of 1:2 was not used. Anti-Terra-U (product of BYK Company), which is a low-molecular-weight acid polymer unsaturated polyamine amide salt solution, was used as the amine-based compound.

### Comparative Example 2

### Preparation of TiO₂ composition for forming photoelectrode

A TiO₂ composition for forming a photoelectrode was prepared in the same manner as in Example 1, except that the mixture including the compound represented by Formula 5 and the compound represented by Formula 6 at a mole ratio of 1:2 was not used.

Table 1 shows final particle diameters (nm) of the second compositions prepared by using the mixture including the compound represented by Formula 3 and the compound represented by Formula 4 in Example 1 and Comparative Example 2, and the amine-based composition prepared according to Comparative Example 1:

**Table 1**

| Hour | Average Particle diameter of the second compositions of Example 1 and Comparative Example 2 (nm) | Particle diameter of the amine-based composition of Comparative Example 1 (nm) |
|---|---|---|
| 0(hr) | 641.95 | 1474.8 |
| 1(hr) | 93.75 | 321.5 |
| 2(hr) | 86.4 | 295.2 |
| 3(hr) | 68.95 | 326.1 |
| 4(hr) | 55.35 | 193.2 |

As shown in Table 1, it was confirmed that the particle sizes of the second compositions prepared by using the mixture including the compound represented by Formula 3 and the compound represented by Formula 4 in Example 1 and Comparative Example 2 were less than that of the amine-based composition of Comparative Example 1.

The mixture including the compound represented by Formula 5 and the compound represented by Formula 6 at a mole ratio of 1:2 was used to change the rheology of the metal oxide composition to be appropriate for printing. Regarding printing, in general, viscosity at a low shear rate is an important factor. Referring FIG. 1, when the mixture including the compound represented by Formula 5 and the compound represented by Formula 6 at a mole ratio of 1:2 is used, viscosity is very low at a low shear rate. Also, referring to FIG. 1, the viscosity of the TiO₂ composition prepared according to Example 1 at the low shear rate is lower than that of the TiO₂ compositions Comparative Example 1 and Comparative Example 2.

### Example 2

### Preparation of Photoelectrode

The TiO₂ composition prepared according to Example 1 was subjected to coating and drying, and then, heat-treating at a temperature of 500°C for about 30 minutes, thereby forming a TiO₂ film, for example, a photoelectrode, having a thickness of about 12µm.

### Comparative Example 3

### Preparation of Photoelectrode

A photoelectrode was manufactured in the same manner as in Example 2, except that the TiO₂ composition prepared according to Comparative Example 1 was used.

Haze and transmittance of TiO₂ films prepared according to Example 2 and Comparative Example 3 were measured and the results are shown in Table 2.

**Table 2**

| | Haze | Transmittance |
|---|---|---|
| Example 2 | 5.68 | 79.8 |
| Comparative Example 3 | 9.33 | 78.94 |

A particle size of a dispersed second composition is related to optical properties of a TiO₂ film. For example, the smaller a particle size of a dispersed second composition, the lower the haze and the higher the transmittance.

As shown in Table 2, the haze of the TiO₂ film prepared according to Example 2 is lower than the haze of the TiO₂ film prepared according to Comparative Example 3. Accordingly, it is confirmed that a photoelectrode for a dye-sensitized solar cell, manufactured using a TiO₂ composition prepared using the mixture including the compound represented by Formula 3 and the compound represented by Formula 4 at a mole ratio of 2:1 as a dispersing agent, is suitable for a BIPV system requiring low haze and high transmittance. Also, when the mixture including the compound represented by Formula 5 and the compound represented by Formula 6 at a mole ratio of 1:2 was used, viscosity of a composition including the mixture at a low shear rate was decreased, thereby improving printing characteristics.

### Example 3

### Manufacturing of Dye-sensitized solar cell

The photoelectrode manufactured according to Example 2 was left at a temperature of 80°C, and then, dipped in a 0.3 mM dye dispersed solution prepared by dissolving 0.3653 g parts by weight of pigment N719 (Solaronix Co., Ltd.) that consists of a Ru complex in IL of ethanol for at least 12 hours to perform a dye adsorption treatment.

Then, the dye-adsorbed photoelectrode was washed with ethanol and dried at room temperature, thereby depositing the photoelectrode on a first electrode.

Separately, a glass substrate coated with FTO was prepared as a substrate for a reference electrode, and a conductive surface of the substrate was masked with an adhesive tape in such a way that an area of the masked portion of the conductive surface was 1.5 cm². Then, the resultant structure was coated with H₂PtCl₆ solution by using a spin coater, and heat treated at a temperature of 500°C for 30 minutes, thereby manufacturing a second electrode as a reference electrode.

An acetonitrile electrolyte including LiI(0.5M) and I(0.05M) was injected into a space between the first electrode and the reference electrode and the resultant structure was sealed to manufacture a dye-sensitized solar cell.

### Comparative Example 4

### Manufacturing of Dye-sensitized solar cell

A dye-sensitized solar cell was manufactured in the same manner as in Example 3, except that the photoelectrode manufactured according to Comparative Example 3 was used.

It was confirmed that the dye-sensitized solar cell manufactured according to Example 2 had lower haze and higher transmittance than the dye-sensitized solar cell manufactured according to Comparative Example 3.

As described above, the photoelectrodes for a dye-sensitized solar cell, according to the one or more of the above embodiments have low haze and high transmittance, which are factors required in a BIPV system.

## Claims

1. A photoelectrode for a dye-sensitized solar cell, the photoelectrode comprising a coating product comprising a metal oxide, an acid, a first additive comprising one or more compounds represented by Formula (1) below, and a second additive comprising one or more compounds represented by Formula (2) below: 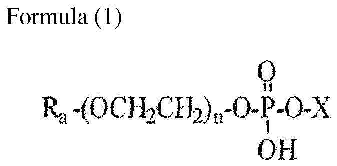 wherein in Formula (1), Rₐ is a C₁₀ to C₃₀ alkyl group, X is a hydrogen atom or -(CH₂CH₂O)ₙ-R_{b}, n is an integer of 1 to 20, and R_{b} is a C₁₀ to C₃₀ alkyl group, and 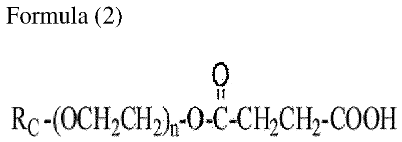 wherein in Formula (2), R_{c} is a C₁₀ to C₃₀ alkyl group, and n is an integer of 1 to 20.

2. The photoelectrode of claim 1, wherein the first additive is a mixture comprising one or more compounds represented by Formula (3) below and one or more compounds represented by Formula (4) below: 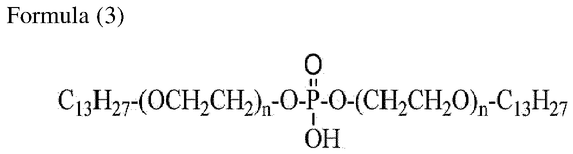 wherein in Formula (3), n is an integer of 1 to 14, and 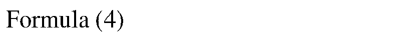 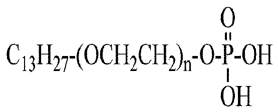 wherein in Formula (4), n is an integer of 1 to 14.

3. The photoelectrode of claim 1 or 2, wherein an amount of the first additive is 1 to 15 parts by weight based on 100 parts by weight of the metal oxide.

4. The photoelectrode of claim 2, wherein a mole ratio of the compound of Formula (3) to the compound of Formula (4) is from 1:4 to 4:1.

5. The photoelectrode of any of the preceding claims, wherein the second additive is a mixture comprising one or more compounds represented by Formula (5) below and one or more compounds represented by Formula (6) below: 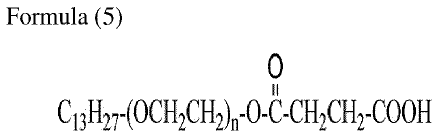 wherein in Formula (5), n is an integer of 1 to 14, and 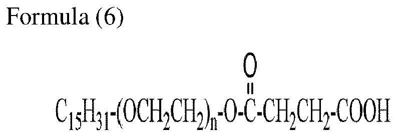 wherein in Formula (6), n is an integer of 1 to 14.

6. The photoelectrode of any of the preceding claims, wherein an amount of the second additive is 1 to 15 parts by weight based on 100 parts by weight of the metal oxide.

7. The photoelectrode of claim 5, wherein a mole ratio of the compound of Formula (5) and the compound of Formula (6) is from 1:4 to 4:1.

8. The photoelectrode of any of the preceding claims, wherein a mole ratio of the first additive to the second additive is from 1:4 to 4:1.

9. The photoelectrode of any of the preceding claims, wherein the metal oxide comprises at least one selected from the group consisting of TiO₂, SnO₂, WO₃, ZnO, SiO₂, ZrO₂, MgO, SrTiO₃, and Al₂O₃.

10. The photoelectrode of any of the preceding claims, wherein the acid comprises at least one selected from the group consisting of a nitric acid, a hydrochloric acid, and an acetic acid.

11. A method of preparing a photoelectrode for a dye-sensitized solar cell, the method comprising:
preparing a first composition by mixing a metal oxide, a first solvent, and an acid;
preparing a second composition by adding a first additive comprising one or more compounds represented by Formula (1) below to the first composition: 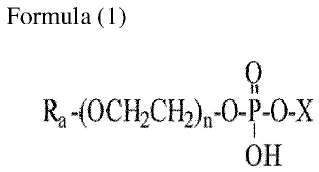
wherein in Formula (1), Rₐ is a C₁₀ to C₃₀ alkyl group, X is a hydrogen atom or -(CH₂CH₂O)ₙ-R_{b}, n is an integer of 1 to 20, R_{b} is a C₁₀ to C₃₀ alkyl group;
preparing a third composition by adding a binder and a second solvent to the second composition;
preparing a metal oxide composition by adding a second additive comprising one or more compounds represented by Formula (2) below to the third composition: 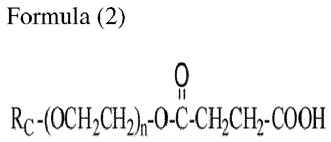
wherein in Formula (2), R_{c} is a C₁₀ to C₃₀ alkyl group, and n is an integer of 1 to 20; and
coating and heat treating the metal oxide composition on a substrate.

12. The method of claim 11, wherein the first solvent and/or the second solvent comprises at least one selected from the group consisting of water, acetone, methanol, ethanol, isoproylalcohol, n-propylalcohol, butanol, α-terpineol, 2-(2-butoxyethoxy)ethyl acetate, tetrahydrofuran (THF), N,N-dimethylforamide (DMF), and hexane.

13. A dye-sensitized solar cell comprising:
a first electrode;
the photoelectrode of any one of claims 1 through 10 formed on a surface of the first electrode;
a second electrode disposed facing the first electrode on which the photoelectrode is disposed; and
an electrolyte disposed between the first electrode and the second electrode.
